# EUROPÄISCHE PATENTANMELDUNG

(11) **EP 2 618 641 A1**
(43) Veröffentlichungstag der Anmeldung: **24.07.2013**
(21) Anmeldenummer: 13150531.5
(22) Anmeldetag: 08.01.2013
(51) Int. Cl.: H05K 1/02

(54) **Bauteilträger, elektrischer Leiter und Verfahren zur Herstellung eines Bauteilträgers sowie eines elektrischen Leiters**

(30) Priorität: 11.01.2012 DE 102012200343
(71) Anmelder: E.G.O. Elektro-Gerätebau GmbH, 75038 Oberderdingen (DE)
(72) Erfinder: Hiller, Axel, 76703 Kraichtal (DE)
(74) Vertreter: Patentanwälte Ruff, Wilhelm, Beier, Dauster & Partner

(57) **Zusammenfassung**

Die Erfindung betrifft eine Leiterplatte (10) für elektronische Bauteile. Sie weist eine erste Kontaktfläche (14) für einen Kontakt an ein erstes Bauteil, eine zweite Kontaktfläche (16) für einen Kontakt an ein zweites Bauteil sowie eine Leiterbahn (12) auf, die die erste und die zweite Kontaktfläche (14, 16) elektrisch leitend verbindet. Die Leiterbahn (12) weist eine Leiterausnehmung (18) auf, die entlang der Leiterbahn (12) verläuft und sich durch die Leiterplatte (10) hindurch erstreckt. In der Leiterausnehmung (18) ist ein elektrischer Leiter (38) angeordnet, der sich über ihren gesamten Verlauf erstreckt und mit der Leiterbahn (12) elektrisch leitend verbunden ist.

## Beschreibung

### Anwendungsgebiet und Stand der Technik

Die Erfindung betrifft einen Bauteilträger, insbesondere eine Leiterplatte, für elektronische und/oder elektrische Bauteile. Die Erfindung betrifft des Weiteren einen elektrischen Leiter eines solchen Bauteilträgers sowie ein Verfahren zur Herstellung eines entsprechenden Bauteilträgers.

Derartige Bauteilträger, elektrische Leiter bzw. Verfahren zu deren Herstellung sind einem Fachmann aus dem Stand der Technik hinreichend bekannt und werden im gesamten Bereich von Elektrotechnik oder dergleichen regelmäßig angewendet. Die elektrischen Leiter, die hier genannt sind, müssen dabei immer in einer Weise dimensioniert werden, die gewährleistet, dass ein akzeptabler Kompromiss zwischen Gesamtplatzbedarf eines Bauteilträgers und Leitungsquerschnitt des elektrischen Leiters erzielt wird. Dabei ist klar, dass sich, je größer der Querschnitt des elektrischen Leiters würde, auch die elektrische Leitfähigkeit des Leiters verbessert. Die Fähigkeit zur Leitung vergleichsweise hoher Ströme ist insbesondere bei der Leistungselektronik gewünscht und erklärtes Ziel.

### Aufgabe und Lösung

Der Erfindung liegt die Aufgabe zu Grunde, einen Bauteilträger, einen elektrischen Leiter sowie ein Verfahren der vorstehend genannten Art bereit zu stellen, mittels denen eine deutlich verbesserte elektrische Leitfähigkeit und Wärmeleitfähigkeit verglichen mit dem Stand der Technik erreicht wird.

Gelöst wird diese Aufgabe durch einen Bauteilträger mit den Merkmalen des Anspruchs 1 sowie durch einen elektrischen Leiter gemäß Anspruch 12 sowie durch ein Verfahren gemäß Anspruch 13. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht. Manche der nachfolgenden, jedoch nicht erschöpfend aufgezählten Merkmale und Eigenschaften treffen auf sowohl den Bauteilträger, den elektrischen Leiter als auch das Verfahren zu. Sie werden teilweise nur einmal beschrieben, gelten jedoch unabhängig voneinander und in beliebiger Kombination sowohl für den Bauteilträger als auch für den elektrischen Leiter sowie für das Verfahren. Weiterhin ist die Reihenfolge der aufgelisteten Merkmale nicht bindend, sondern kann vielmehr entsprechend eines optimierten Bauteilträgers, eines optimierten elektrischen Leiters bzw. eines optimierten Verfahrens geändert und kombiniert werden.

Erfindungsgemäß ist ein Bauteilträger, insbesondere eine Leiterplatte, für elektronische und/oder elektrische Bauteile vorgesehen, der flächig bzw. flach ausgebildet ist und eine erste Seite sowie eine der ersten Seite gegenüberliegenden zweite Seite aufweist. Dabei weist der Bauteilträger eine erste Kontaktfläche für einen Kontakt an ein erstes, insbesondere elektronisches, Bauteil sowie eine zweite Kontaktfläche für einen Kontakt an ein zweites, insbesondere elektronisches, Bauteil auf. Des weiteren weist der Bauteilträger eine Leiterbahn auf, die die erste Kontaktfläche und die zweite Kontaktfläche elektrisch leitend verbindet und die auf der ersten Seite des Bauteilträgers angeordnet ist. Der Bauteilträger weist eine Leiterausnehmung auf, die sich ausgehend von der ersten Seite oder der zweiten Seite in Richtung zu der jeweils anderen Seite erstreckt, wobei diese Leiterausnehmung entlang der Leiterbahn verläuft. In der Leiterausnehmung ist ein sich im Wesentlichen über ihren gesamten Verlauf erstreckender, elektrischer Leiter angeordnet, der mit der Leiterbahn elektrisch leitend verbunden ist. Die Leiterausnehmung erstreckt sich hierbei nicht nur durch die Leiterbahn hindurch, sondern auch zumindest teilweise durch das elektrisch nicht leitende Trägermaterial des Bauteilträgers, beispielsweise eine üblicherweise für Leiterplatten verwendete Kunstharzplatte. Durch die Anordnung des elektrischen Leiters entlang der Leiterbahn wird nicht nur das Leiterbahnmaterial ersetzt, das aufgrund der Ausnehmung nicht mehr vorhanden ist, sondern außerdem zusätzliches Leitermaterial für die elektrische Verbindung der ersten Kontaktfläche mit der zweiten Kontaktfläche bereitgestellt. Insgesamt wird also der Leitungsquerschnitt zumindest zwischen den Kontaktflächen in relevantem Maße vergrößert. Dabei wird jedoch die ursprüngliche Peripherie des Bauteilträgers im Wesentlichen beibehalten, zumindest jedoch lediglich in geringem Maße vergrößert, da die Vergrößerung des Leiterquerschnitts im Wesentlichen im Inneren des Bauteilträgers erfolgt bzw. in seine Tiefe geht.

Ein elektrischer Leiter im Sinne der Erfindung kann beispielsweise ein Draht, ein Blechstreifen oder dergleichen sein. Aber auch ein elektrisch leitender Kunststoff, Lack oder dergleichen kann, sofern im Rahmen der Erfindung sinnvoll, in Ausgestaltungen der Erfindung verwendet werden.

Die Leiterausnehmung erstreckt sich vorzugsweise so weit bis in den Bereich der ersten und zweiten Kontaktfläche, dass der einzusetzende bzw. anzuordnende elektrische Leiter im gesamten Bereich des Strompfades zwischen erster Kontaktfläche und zweiter Kontaktfläche Teil dieses Strompfades ist. Ansonsten wäre beispielsweise die Leiterbahn das schwächste Glied des Strompfades.

In Ausgestaltung der Erfindung erstreckt sich die Leiterausnehmung vollständig ausgehend von der ersten Seite bis zur zweiten Seite, also vollständig durch den Bauteilträger hindurch. Entsprechend ist dann vorteilhaft der elektrische Leiter so gewählt bzw. ausgebildet, dass der gesamte zur Verfügung stehende Raum in der Leiterausnehmung von diesem elektrischen Leiter ausgefüllt wird. Es ist ersichtlich, dass, je größer der zusätzliche elektrische Leiter in der Leiterausnehmung ist, desto höher die verwendbaren Ströme sind.

Bevorzugt ist die Leiterbahn breiter als die Leiterausnehmung, vorteilhaft zwischen 1,5 mal so breit und 5 mal so breit.

In Weiterbildung der Erfindung verläuft die Leiterausnehmung mittig entlang der Leiterbahn und unterbricht diese insbesondere dort. Auf diese Weise wird eine gleichmäßige Verteilung von Leiterbahn und Leiterausnehmung erreicht. Die Leiterbahn kann als Positionsmarke verwendet werden, beispielsweise für eine Fräsvorrichtung oder dergleichen. Die gleichmäßige Verteilung bzw. die mittige Unterbrechung der Leiterbahn zeigt sich außerdem vorteilhaft bei der Verwendung von Lötstopp, aber auch bei der Metallisierung von so genannten frei gewordenen Oberflächen im Bereich der Ausnehmung.

In Weiterbildung der Erfindung ist eine Seitenwand, insbesondere sind beide Seitenwände, der Leiterausnehmung mit einer elektrisch leitenden Schicht als Teil des Leiters versehen, vorteilhaft sind sie metallisiert, insbesondere mit dem gleichen Material wie die Leiterbahn. Dieses Material kann vorzugsweise, jedoch nicht ausschließlich, Kupfer sein. Diese Ausgestaltung erhöht die elektrische Leitfähigkeit und die Wärmeleitfähigkeit der Leiterbahn, schützt die Kanten bzw. Seitenwände der Leiterausnehmung und stabilisiert den Bauteilträger. Weiterhin erhöht sich auf diese Weise die Kontaktfläche zwischen Leiterbahn und dem in der Leiterausnehmung anzuordnenden elektrischen Leiter, was auch vorteilhaft ist für die Stromleitung zwischen den beiden Kontaktflächen.

In weiterer Ausgestaltung der Erfindung ist die Leiterbahn im Bereich der Kontaktfläche breiter als im Bereich zwischen den Kontaktflächen entlang der Ausnehmungen. Auf diese Weise wird eine große bzw. im Vergleich größere Auflagefläche für Lötzinn oder dessen Äquivalent bei der Kontaktierung von elektrischen Bauteilen mit den Kontaktflächen bereitgestellt. Weiterhin wird mittels des aufgetragenen Lötzinns bzw. dessen Äquivalent eine Leiterquerschnittsvergrößerung im Bereich der Kontaktflächen erreicht, wobei sich diese Vergrößerung dann vorzugsweise bis in den Bereich der Leiterausnehmungen erstreckt.

In weiterer Ausgestaltung der Erfindung weist die Leiterbahn im Bereich einer Kontaktfläche eine die Kontaktfläche vorzugsweise napfartig und/oder vollständig oder nur teilweise ringartig umgebende Kontaktausnehmung auf, die vorzugsweise in die Leiterbahnausnehmung übergeht. Diese Kontaktausnehmung geht von der freien Oberfläche der Kontaktfläche aus und erstreckt sich in den Bauteilträger hinein. Mittels der Kontaktausnehmung wird zusätzlicher Raum geschaffen, um einen elektrischen Leiter gemäß vorstehender Beschreibung aufzunehmen.

In Ausgestaltung der Erfindung sind Leiterausnehmung und/oder Kontaktausnehmung mit Lötzinn gefüllt. Vorteilhaft wird so der elektrische Leiter in und/oder an der Leiterausnehmung während eines ohnehin notwendigen Arbeitsschrittes hergestellt, besonders vorteilhaft während des Verlötens, beispielsweise mittels eines Lötbades, Wellenlötens odgl..

In Ausgestaltung der Erfindung bilden der Leiter, eine Kontaktausnehmung, die Leiterbahn, die Kontaktflächen sowie aufgetragenes Lötzinn gemeinsam einen elektrischen Leiter, vorzugsweise mit einem näherungsweise durchgängigen, vorzugsweise konstanten Leiterquerschnitt. In weiterer Ausgestaltung der Erfindung ist entlang der Leiterausnehmung ein elektrisch leitendes Bauteil angeordnet, vorzugsweise ein Draht, eine Metallbrücke oder dergleichen, das elektrisch leitend mit der Leiterbahn verbunden ist, vorzugsweise mittels Lötzinn bzw. dessen Äquivalent, und zwar entlang des Verlaufs der Leiterausnehmung. Auf diese Weise wird, je nach verwendetem Material für den zusätzlichen elektrischen Leiter, die elektrische Leitfähigkeit und Wärmeleitfähigkeit des Gesamtleiters in dem Bereich zwischen den Kontaktflächen weiter vergrößert.

In Weiterbildung der Erfindung sind entlang eines Leiters mehrere Leiterausnehmungen vorgesehen, vorzugsweise zwei oder drei, insbesondere parallel zueinander und/oder gleich ausgebildet. Auf diese Weise wird eine weitere Vergrößerung des verfügbaren Leiterquerschnitts erreicht.

In Ausgestaltung der Erfindung beträgt das Verhältnis zwischen der Breite der Leiterbahn und der Breite der Leiterausnehmung zwischen 1:0,9 und 1:0,1, insbesondere zwischen 1:0,7 und 1:0,3. In weiterer Ausgestaltung der Erfindung ist die Breite der Leiterausnehmung kleiner als die Dicke des Bauteilträgers und die Breite ist mehr als doppelt so groß wie die Dicke der Leiterbahn. Ein ideales Verhältnis kann gefunden werden durch die Kombination von Fließeigenschaften, beispielsweise des Lötzinns, einer notwendigen Stabilität des Bauteilträgers sowie eines zu erzielenden Leiterquerschnitts.

Die der Erfindung zugrundeliegende Aufgabe wird außerdem durch einen elektrischen Leiter eines vorstehend beschriebenen Bauteilträgers gelöst, wobei der elektrische Leiter wenigstens aus einer Leiterbahn, angeordnet auf der ersten Seite und/oder der zweiten Seite des Bauteilträgers, sowie aus einem Leiter besteht, der in einer Leiterausnehmung angeordnet ist. Dabei erstreckt sich diese Leiterausnehmung ausgehend von einer der Seiten in Richtung zu der anderen Seite und verläuft im Wesentlichen parallel zu der Leiterbahn.

Die der Erfindung zugrundeliegende Aufgabe wird des weiteren noch durch ein Verfahren zur Herstellung eines vorstehend beschriebenen Bauteilträgers gelöst, wobei der Bauteilträger eine Leiterbahn aufweist, die auf einer ersten Seite und/oder einer zweiten Seite des Bauteilträgers angeordnet ist, und wobei der Bauteilträger eine erste und eine zweite Kontaktfläche aufweist. In einem Verfahrensschritt wird eine Leiterausnehmung in den Bauteilträger im Bereich der Leiterbahn im Wesentlichen entlang der Leiterbahn eingebracht, wobei sich die Leiterausnehmung ausgehend von einer Seite in Richtung zu der anderen Seite erstreckt. Dies kann bei einer schon vorhandenen beziehungsweise zuvor aufgebrachten Leiterbahn erfolgen, diese also durchtrennt werden. Alternativ kann es erfolgen, bevor die Leiterbahn aufgebracht wird bzw. überhaupt vor einem Verkupfern der Leiterbahn.

In einem weiteren nachfolgenden Schritt wird ein Leiter in der Leiterausnehmung angeordnet, gegebenenfalls zusammen mit der Leiterbahn beim Metallisieren. In einem weiteren Schritt wird gegebenenfalls eine elektrisch leitende Verbindung zwischen der Leiterbahn und dem Leiter erzeugt, wenn sie nicht schon vorher erzeugt worden ist.

In alternativer Ausgestaltung des Verfahrens wird zur Herstellung der elektrisch leitenden Verbindung Lötzinn bzw. eines seiner Äquivalente in die Leiterausnehmung gefüllt, wobei vorzugsweise die Leiterausnehmung vollständig mit Lötzinn gefüllt wird. Dann fallen die Schritte des Anordnens des Leiters und des Verbindens mit der Leiterbahn zusammen.

In weiterer Ausgestaltung des Verfahrens werden die Seitenwände der Leiterausnehmung elektrisch leitend beschichtet, vorzugsweise mit demselben Material, aus dem die Leiterbahn besteht, insbesondere mit Kupfer. Dies kann zuvor oder hinterher erfolgen.

Diese und weitere Merkmale gehen außer aus den Ansprüchen auch aus der Beschreibung und den Zeichnungen hervor, wobei die einzelnen Merkmale jeweils für sich alleine oder zu mehreren in Form von Unterkombinationen bei einer Ausführungsform der Erfindung und auf anderen Gebieten verwirklicht seien und vorteilhafte sowie für sich schutzfähige Ausführungen darstellen können, für die hier Schutz beansprucht wird. Die Unterteilung der Anmeldung in einzelne Abschnitte und Zwischenüberschriften beschränken die unter diesen gemachten Aussagen nicht in ihrer Allgemeingültigkeit.

### Kurzbeschreibung der Zeichnungen

Verschiedene Ausführungsformen der Erfindung sind in den Zeichnungen schematisch dargestellt und werden im Folgenden näher erläutert. Die in den einzelnen Figuren gezeigten Ausführungsformen weisen teilweise Merkmale auf, die die anderen dargestellten Ausführungsformen der Erfindung nicht aufweisen. Die Merkmale können jedoch, ohne den Rahmen der Erfindung zu verlassen, beliebig miteinander kombiniert werden. In den Zeichnungen zeigen:
- Fig.1: eine auf einem erfindungsgemäßen Bauteilträger angeordnete Leiterbahn gemäß einer ersten Ausgestaltung,
- Fig.2: eine auf einem erfindungsgemäßen Bauteilträger angeordnete Leiterbahn gemäß einer zweiten Ausgestaltung,
- Fig.3: eine auf einem erfindungsgemäßen Bauteilträger angeordnete Leiterbahn gemäß einer dritten Ausgestaltung,
- Fig.4: eine Schnittansicht eines erfindungsgemäßen Bauteilträgers gemäß Linie I-I in Fig.1,
- Fig.5: eine Schnittansicht eines erfindungsgemäßen Bauteilträgers gemäß Linie II-II in Fig.1,
- Fig.6: eine Schnittansicht eines erfindungsgemäßen Bauteilträgers gemäß Linie III-III in Fig.2,
- Fig.7: eine Schnittansicht eines erfindungsgemäßen Bauteilträgers gemäß Linie IV-IV in Fig.3, sowie
- Fig.8: eine Schnittansicht eines erfindungsgemäßen Bauteilträgers entsprechend Fig.7, jedoch in einer anderen Ausführung.

### Detaillierte Beschreibung der Ausgestaltungen

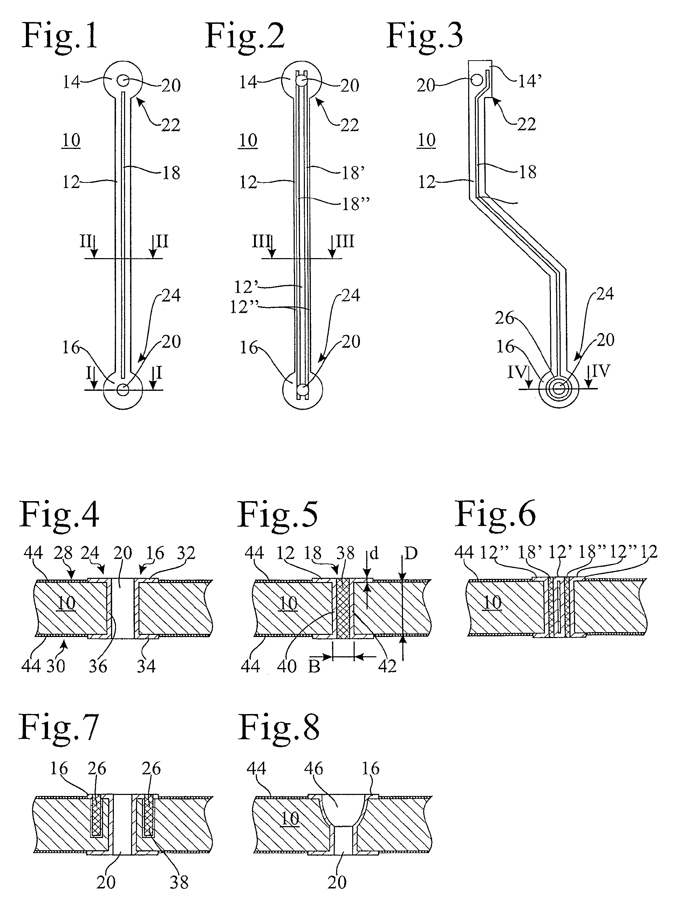

In Fig. 1 ist ein erfindungsgemäßer flächiger Bauteilträger 10 dargestellt, z. B. eine Leiterplatte, der eine Leiterbahn 12 mit einer ersten Kontaktfläche 14 und einer zweiten Kontaktfläche 16 vollständig seitlich umgibt bzw. dafür als Träger dient. Die Leiterbahn 12 ist gemäß Fig. 1 in ihrem Verlauf mit einer mittigen Leiterausnehmung 18 versehen die, wie aus den Fig. 5, 6 und 7 noch hervorgehen wird, zumindest teilweise mit einem elektrischen Leiter gefüllt ist. Die erste Kontaktfläche 14 und die zweite Kontaktfläche 16 weisen jeweils eine runde Ausnehmung 20 für die Aufnahme von Kontaktstiften, -fahnen oder dergleichen von insbesondere elektrischen Bauelemente auf. Die Leiterbahn 12 besteht üblicherweise aus Kupfer, alternativ aus jedem anderen für die Verwendung in einer Leiterplatte verwendbaren Metall bzw. elektrisch leitenden Material. Die in Fig. 1 nicht dargestellten Stifte bzw. Fahnen der elektrischen Bauelemente werden in bekannter Weise mit der ersten Kontaktfläche 14 bzw. zweiten Kontaktfläche 16 verlötet, z.B. in einem Lötbad.

Im Unterschied zu Fig. 1 sind in Fig. 2 zwei Leiterausnehmungen 18", 18" vorgesehen. Diese Leiterausnehmungen 18', 18" verlaufen wie die Leiterausnehmung 18 der Fig. 1 im Wesentlichen parallel und entlang sowie innerhalb der Leiterbahn 12. Die Leiterbahn 12 wird durch die Leiterausnehmungen 18', 18" unterteilt in einen Leiterbahnsteg 12' sowie zwei den Leiterbahnsteg 12'flankierende Leiterbahn-Außenbereiche 12". Die Leiterausnehmungen 18', 18" erstrecken sich jeweils bis in den Bereich 22 der ersten Kontaktfläche 14 bzw. den Bereich 24 der zweiten Kontaktfläche 16, und darin jeweils über die Ausnehmungen 20 hinaus. Vorteilhaft erstrecken sich die Leiterausnehmungen 18', 18" in den Bereichen 22, 24 nicht vollständig durch den Bauteilträger 10 hindurch, damit der Steg mit dem restlichen Bauteilträger 10 verbunden bleibt. Im Unterschied zu Fig. 2 endet die Leiterausnehmung 18 der Fig. 1 kurz vor der Ausnehmung 20. Beiden Ausgestaltungen sind Vorteile zuzuerkennen. So ist gemäß Fig. 1 eine deutlich vereinfachte Erzeugung der Ausnehmung 18 möglich, die darüber hinaus auch noch eine große Stabilität für den Bauteilträger 10 bereit stellt, insbesondere auch im Bereich der Ausnehmungen 20. Durch die Fortführung der Ausnehmungen 18', 18" der Fig. 2 bis in den Bereich der Ausnehmungen 20, bzw. über die Ausnehmungen 20 hinaus wird eine sehr gute elektrische Kontaktierung auch des in der jeweiligen Ausnehmung 18 angeordneten, nicht dargestellten elektrischen Leiters mit den ebenfalls nicht dargestellten Kontaktstiften bzw. -fahnen der elektrischen Bauteile erzeugt. Unter Umständen können allgemein die Leiter samt Leiterausnehmung etwas abgebogen sein, um gerade an den Kontaktstiften anzuliegen.

Die Leiterbahn 12 der Fig. 3 ist im Unterschied zu den Leiterbahnen der Fig. 1 und 2 in ihrem Verlauf zweimal abgewinkelt ausgeführt. Diese Ausgestaltung soll als Beispiel für jeden beliebigen Verlauf von Leiterbahnen 12 auf den Bauteilträgern 10 dienen, der gegebenenfalls auch deutlich länger und/oder auch verzweigt sein kann. Des Weiteren unterscheidet sich die erste Kontaktfläche 14' der Fig. 3 von der ersten Kontaktfläche 14 der Fig. 1 und 2 durch ihre nicht kreisförmige Kontur. Darin ist außerdem die Leiterausnehmung 18 so ausgebildet, dass sie an der Ausnehmung 20 der ersten Kontaktfläche 14' vorbeiläuft. Die zweite Kontaktfläche 16 weist eine Kontaktausnehmung 26 auf, die direkt in die Leiterausnehmung 18 übergeht. Die Kontaktausnehmung 26 umgibt die Ausnehmung 20 ringförmig, durchdringt den Bauteilträger 10 jedoch nicht vollständig.

In Fig. 4 ist eine Schnittdarstellung des Bauteilträgers 10 im Bereich 24 der zweiten Kontaktfläche 16 entsprechend Linie I - I der Fig. 1 dargestellt. Die Ausnehmung 20 durchtritt den Bauteilträger von dessen erster Seite 28 bis zu dessen zweiter Seite 30. Die erste Kontaktfläche 16 besteht aus einem Teil 32, der auf der ersten Seite 28 angeordnet ist, einem zweiten Teil 34, der auf der Seite 30 angeordnet ist, sowie einem dritten Teil 36, der den Bauteilträger 10 durchtritt, beziehungsweise an einer Innenwandung angeordnet ist. Diese Teile sind in einer für den Fachmann geläufigen Weise ausgebildet und entstehen beispielsweise durch Ätzen der Oberfläche sowie Metallisieren, beispielsweise nach dem Erzeugen der Ausnehmung 20.

In Fig. 5 ist eine Schnittansicht der Leiterbahn 12 der Fig. 1 gemäß Linie II - II dargestellt. Die Leiterbahn 12 ist mit einer Leiterausnehmung 18 versehen, in der ein elektrischer Leiter 38 angeordnet ist. Dieser elektrische Leiter 38 ist hier beispielsweise Lötzinn, das insbesondere in einem ohnehin normalerweise vorgenommenen Lötbad dem Bauteilträger 10 zugeführt wird. Es ist der Fig. 5 zu entnehmen, dass die Seitenwand 40 der Leiterausnehmung 18 mit einer elektrisch leitenden Schicht 42 versehen ist, die im Wesentlichen dem Material der Leiterbahn 12 entspricht. Es ist ersichtlich, dass durch das Vorhandensein des elektrischen Leiters 38 der Leiterquerschnitt der Leiterbahn 12 erheblich vergrößert wird.

Es hat sich als vorteilhaft herausgestellt, die Breite B der Leiterausnehmung 18 kleiner zu wählen als die Dicke D des Bauteilträgers 10. Des Weiteren sollte vorteilhaft die Breite B mehr als doppelt so groß sein wie die Dicke d der Leiterbahn 12.

Um ein ungewünschtes Ausbreiten des Lötzinns auf der Oberfläche des Bauteilträgers 10 über den Bereich der Leiterbahn 12 hinaus zu verhindern, ist der Bauteilträger 10 in diesen im Wesentlichen ungenutzten Bereichen mit sogenanntem Lötstopplack 44 odgl. versehen.

In Fig. 6 ist eine Ausgestaltung der Leiterbahn 12 aus Fig. 5 dargestellt, wobei die Darstellung der Fig. 6 der Schnittlinie III - III aus Fig. 2 entspricht. Es ist ersichtlich, dass die Leiterbahn 12 zwei Leiterausnehmungen 18', 18" aufweist, deren prinzipieller Aufbau dem der Leiterbahn 12 aus Fig. 5 entspricht. Diese Leiterausnehmungen 18', 18" unterteilen die Leiterbahn 12 in einen Leiterbahnsteg 12' und zwei Leiterbahn-Außenbereiche 12", die den Leiterbahnsteg 12' flankieren. Es ist ersichtlich, dass zwischen dem Leiterbahnsteg 12' und wenigstens einem der Leiterbahn-Außenbereiche 12" nach dem Erzeugen der Leiterausnehmungen 18', 18" eine Verbindung bestehen bleiben sollte, ähnlich wie in Bezug auf Fig.2 bzw. wie nachfolgend in Bezug auf Fig.7 beschrieben.

Die Fig. 7 zeigt die zweite Kontaktfläche 16 entsprechend Schnittlinie IV - IV aus Fig. 3. Die Kontaktfläche 16 ist mit einer Kontaktausnehmung 26 versehen, die die Ausnehmung 20 ringförmig umgibt und die Leiterplatte zumindest teilweise zu etwa 75% durchdringt. Die Kontaktausnehmung 26 ist, entsprechend der Leiterausnehmungen 18, 18', 18", mit einem elektrischen Leiter 38 versehen. Der elektrische Leiter 38 bildet, wie auch schon die vorangegangenen elektrischen Leiter, zusammen mit der Leiterbahn 12 und den Kontaktflächen 14, 16 einen gemeinsamen Strompfad mit einem Mindestquerschnitt. So können höhere Ströme transportiert werden, als dies ohne die Leiterausnehmung bzw. Kontaktausnehmung 26 mit dem Leiter 38 darin der Fall wäre.

Die Fig. 8 zeigt eine weitere Ausgestaltung der zweiten Kontaktfläche der Fig. 7. Diese weist eine napfartige Ausnehmung 46 auf, die in die Ausnehmung 20 übergeht. Es ist zu erkennen, dass im Bereich 46 nach dem Verlöten eines nicht dargestellten Bauteiles, bzw. dessen Kontaktstifte und/oder -fahnen mehr Lötzinn bzw. dessen Äquivalent vorhanden sein wird als im Bereich 20. Auf diese Weise wird ebenfalls der verfügbare elektrische Leitungsquerschnitt erhöht.

## Patentansprüche

1. Bauteilträger, insbesondere Leiterplatte, für elektronische und/oder elektrische Bauteile, wobei der Bauteilträger (10) flächig bzw. flach ausgebildet ist und eine erste Seite (28) sowie eine der ersten Seite (28) gegenüberliegenden zweite Seite (30) aufweist, wobei der Bauteilträger (10) eine erste Kontaktfläche (14) für einen Kontakt an ein erstes Bauteil sowie eine zweite Kontaktfläche (16) für einen Kontakt an ein zweites Bauteil aufweist, und wobei der Bauteilträger (10) eine Leiterbahn (12) aufweist, die die erste Kontaktfläche (14) und die zweite Kontaktfläche (16) elektrisch leitend verbindet und die auf der ersten Seite (28) des Bauteilträgers (10) angeordnet ist,
**dadurch gekennzeichnet, dass**
der Bauteilträger (10) eine Leiterausnehmung (18) aufweist, die sich ausgehend von der ersten Seite (28) oder der zweiten Seite (30) in Richtung zu der anderen Seite (30, 28) erstreckt, wobei diese Leiterausnehmung (18) entlang der Leiterbahn (12) verläuft und wobei in der Leiterausnehmung (18) ein sich im Wesentlichen über ihren gesamten Verlauf erstreckender, elektrischer Leiter (38) angeordnet ist, der mit der Leiterbahn (12) elektrisch leitend verbunden ist.

2. Bauteilträger nach Anspruch 1, **dadurch gekennzeichnet, dass** sich die Leiterausnehmung (18) vollständig ausgehend von der ersten Seite (28) bis zur zweiten Seite (30) durch den Bauteilträger (10) hindurch erstreckt.

3. Bauteilträger nach Anspruch 1 oder 2, **dadurch gekennzeichnet, dass** die Leiterbahn breiter als die Leiterausnehmung ist, vorzugsweise zwischen 1,5 mal so breit und 5 mal so breit.

4. Bauteilträger nach einem der vorstehenden Ansprüche, **dadurch gekennzeichnet, dass** die Leiterausnehmung (10) mittig entlang der Leiterbahn (12) verläuft und insbesondere diese dort unterbricht.

5. Bauteilträger nach einem der vorstehenden Ansprüche, **dadurch gekennzeichnet, dass** eine Seitenwand (40), vorzugsweise beide Seitenwände (40), der Leiterausnehmung (18) mit einer elektrisch leitenden Schicht (42) als Teil des Leiters (38) versehen sind, insbesondere metallisiert sind, insbesondere mit gleichem Material wie die Leiterbahn (12).

6. Bauteilträger nach einem der vorstehenden Ansprüche, **dadurch gekennzeichnet, dass** die Leiterbahn (12) im Bereich (22, 24) der Kontaktflächen (14, 16) breiter ist als im Bereich zwischen den Kontaktflächen (14, 16) entlang der Ausnehmungen (18).

7. Bauteilträger nach einem der vorstehenden Ansprüche, **dadurch gekennzeichnet, dass** die Leiterbahn (12) im Bereich (22, 24) einer Kontaktfläche (14, 16) eine die Kontaktfläche (14, 16) umgebende Kontaktausnehmung (26) aufweist, die in die Leiterausnehmung (18) übergeht, wobei insbesondere die Leiterausnehmung (18) und/oder eine Kontaktausnehmung (26) mit Lötzinn gefüllt sind, wobei vorzugsweise der Leiter (38), eine Kontaktausnehmung (26), die Leiterbahn (12), die Kontaktflächen (14, 16) sowie aufgetragenes Lötzinn gemeinsam einen elektrischen Leiter (38) mit einem Leiterquerschnitt bilden.

8. Bauteilträger nach einem der vorstehenden Ansprüche, **dadurch gekennzeichnet, dass** entlang der Leiterausnehmung (18) ein elektrisch leitendes Bauteil angeordnet ist, vorzugsweise ein Draht, eine Kontaktbrücke oder dergleichen, der elektrisch leitend mit der Leiterbahn (12) verbunden ist, vorzugsweise mittels Lötzinn entlang des Verlaufs der Leiterausnehmung (18).

9. Bauteilträger nach einem der vorstehenden Ansprüche, **dadurch gekennzeichnet, dass** entlang eines Leiters (38) mehrere Leiterausnehmungen (18, 18', 18") vorgesehen sind, vorzugsweise zwei oder drei, insbesondere parallel zueinander und/oder gleich ausgebildet.

10. Bauteilträger nach einem der vorstehenden Ansprüche, **dadurch gekennzeichnet, dass** das Verhältnis zwischen der Breite der Leiterbahn (12) und der Breite der Leiterausnehmung (18) zwischen 1:0,9 und 1:0,1 beträgt, insbesondere zwischen 1:0,7 und 1:0,3.

11. Bauteilträger nach Anspruch 10, **dadurch gekennzeichnet, dass** die Breite B der Leiterausnehmung (18) kleiner als die Dicke D des Bauteilträgers (10) ist, und/oder dass die Breite B mehr als doppelt so groß ist wie die Dicke d der Leiterbahn (12).

12. Elektrischer Leiter eines Bauteilträgers, vorzugsweise nach einem der vorstehenden Ansprüche, **dadurch gekennzeichnet, dass** der elektrische Leiter wenigstens aus einer Leiterbahn (12) angeordnet auf einer ersten Seite (28) und/oder einer zweiten Seite (30) des Bauteilträgers (10) sowie aus einem Leiter (38) besteht, der in einer Leiterausnehmung (18) angeordnet ist, wobei sich diese Leiterausnehmung (18) ausgehend von der ersten Seite (28) oder der zweiten Seite (30) in Richtung zu der anderen Seite (30, 28) erstreckt und im Wesentlichen parallel zu der Leiterbahn (12) verläuft.

13. Verfahren zur Herstellung eines Bauteilträgers, vorzugsweise nach einem der Ansprüche 1 bis 11, mit einer Leiterbahn (12), die auf einer ersten Seite (28) und/oder einer zweiten Seite (30) des Bauteilträgers (10) angeordnet ist und einer ersten und einer zweiten Kontaktfläche (14, 16), **gekennzeichnet durch** die Schritte:
• Einbringen einer Leiterausnehmung (18) in den Bauteilträger (10) im Bereich der Leiterbahn (12) im Wesentlichen entlang der Leiterbahn (12), wobei sich die Leiterausnehmung (18) ausgehend von einer Seite (28) in Richtung zu der anderen Seite (30) erstreckt,
• Anordnen eines Leiters (38) in der Leiterausnehmung (18),
• ggf. Erzeugen einer elektrisch leitenden Verbindung zwischen der Leiterbahn (12) und dem Leiter (38).

14. Verfahren nach Anspruch 13, **dadurch gekennzeichnet, dass** zur Herstellung der elektrisch leitenden Verbindung Lötzinn in die Leiterausnehmung (18) gefüllt wird, wobei vorzugsweise die Leiterausnehmung (18) vollständig mit Lötzinn gefüllt wird.

15. Verfahren nach einem der Ansprüche 13 oder 14, **dadurch gekennzeichnet, dass** die Seitenwände (40) der Leiterausnehmung (18) elektrisch leitend beschichtet werden, vorzugsweise mit demselben Material, aus dem die Leiterbahn (12) besteht.
